(19) Europäisches Patentamt
European Patent Office
Office européen des brevets

(11) **EP 0 662 209 B1**

(12) **EUROPÄISCHE PATENTSCHRIFT**

(45) Veröffentlichungstag und Bekanntmachung des Hinweises auf die Patenterteilung:
**26.03.1997 Patentblatt 1997/13**

(21) Anmeldenummer: **93920802.1**

(22) Anmeldetag: **22.09.1993**

(51) Int Cl.⁶: **F25B 21/04**

(86) Internationale Anmeldenummer:
**PCT/EP93/02571**

(87) Internationale Veröffentlichungsnummer:
**WO 94/07094 (31.03.1994 Gazette 1994/08)**

(54) **THERMOELEKTRISCHE HEIZ- ODER KÜHLVORRICHTUNG**

THERMOELECTRIC HEATING OR COOLING DEVICE

DISPOSITIF THERMOELECTRIQUE DE CHAUFFAGE OU DE REFRIGERATION

(84) Benannte Vertragsstaaten:
**BE CH DE FR GB IT LI NL SE**

(30) Priorität: **22.09.1992 DE 4231702**

(43) Veröffentlichungstag der Anmeldung:
**12.07.1995 Patentblatt 1995/28**

(73) Patentinhaber: **LITEF GmbH**
**D-79115 Freiburg (DE)**

(72) Erfinder: **KESSLER, Rolf**
**D-79249 Merzhausen (DE)**

(74) Vertreter: **Müller, Frithjof E., Dipl.-Ing.**
**Patentanwälte**
**MÜLLER & HOFFMANN,**
**Innere Wiener Strasse 17**
**81667 München (DE)**

(56) Entgegenhaltungen:
| | |
|---|---|
| DE-A- 1 817 058 | US-A- 2 978 875 |
| US-A- 2 998 707 | US-A- 3 088 288 |
| US-A- 3 091 939 | US-A- 3 934 758 |
| US-A- 4 671 070 | US-A- 4 833 889 |

**Beschreibung**

Die Erfindung betrifft eine thermoelektrische Heiz- oder Kühlvorrichtung nach dem Oberbegriff des Patentanspruchs 1. Eine Vorrichtung dieser Gattung ist aus der Druckschrift DD-A-0 049 626 bekannt.

Mit Peltier-Bausteinen ausgerüstete Kälteerzeuger. die bekanntlich auch in umgekehrter Richtung, d.h. sofern durch ein Gehäuse umgeben, auch als Wärmekammer betrieben werden können. haben gegenüber Kompressorgeräten den großen Vorteil, daß sie elektrisch sehr genau regelbar sind auf eine Temperaturkonstanz, die mit anderen Kältetechniken nicht zu erreichen ist. Peltier-Heiz-/Kühlkammern bekannter Bauart haben jedoch den Nachteil, daß der einstellbare Temperaturbereich zu begrenzt ist und/oder daß der Aufwand für die "wegzupumpende" Verlustleistung zu groß wird. Die in der Regel in Kaskadenanordnung verbundenen plattenförmigen Peltier-Elemente lassen sich dann (vor allem in den Randzonen) nicht ausreichend gegen Überhitzung schützen. Dies gilt sowohl für Peltier-Kaskaden in einer Ebene (vgl. GB-A-2 241 378) als auch in verstärktem Maße für pyramidenförmige Anordnungen mehrerer Peltier-Kaskaden (vgl. DD-A- 0 049 626 und US-A-48 33 889).

Eine Leistungsbegrenzung der thermoelektrischen Elemente in Abhängigkeit ihrer Temperatur ist aus der US-A-4 671 070 bekannt.

Mit den aus den genannten Druckschriften bekannten Lösungen ist jedoch nur ein eingeschränkter Heizbetrieb der Kaskadenanordnung von Peltier-Elementen möglich. und zwar deshalb, weil es leicht zu einer Überhitzung eines Teils der Peltier-Elemente kommt. Daraus ergeben sich weitere Nachteile wie die, daß

-   wegen dessen eingeschränkten Heizbetriebs keine schnellen Temperaturänderungen bis zur oberen Temperaturgrenze zulässig und möglich sind,
-   im Heizbetrieb höhere elektrische Leistung erforderlich wird, und
-   ein schneller Verschleiß durch Verunreinigung des Halbleitermaterials einerseits und Materialverspannungen durch höhere Ausdehnungen andererseits auftreten.

Der Erfindung liegt die Aufgabe zugrunde, ein thermoelektrisch betriebenes Heiz-/Kühlaggregat, insbesondere eine Heiz-/Kühlkammer mit entsprechender Wärmeisolation zu schaffen, sie sich in einem wesentlich größeren Temperaturbereich betreiben läßt, ohne daß der Aufwand für die abzuführende Verlustleistung unvertretbar groß wird.

Die Lösung dieser Aufgabe wird bei einer thermoelektrischen Heiz- oder Kühlvorrichtung gemäß der eingangs genannten Gattung durch die kennzeichnenden Merkmale des Patentanspruchs 1 erreicht.

Vorteilhafte Weiterbildungen und Ergänzungen der Erfindung sind in jeweils abhängigen Patentansprüchen definiert.

Die Bypaßdiode kann entweder alle in Kaskade geschalteten Peltier-Elemente höherer Leistung elektrisch überbrücken oder sie kann zumindest einzelnen der Peltier-Elemente höherer Leistung individuell zugeordnet sein. Im letzteren Fall können die einzelnen Bypaßdioden in das jeweils zugeordnete Peltier-Element integriert sein.

Die erste und zweite Gruppe der plattenförmigen Peltier-Elemente kann jeweils in Vertiefungen einer gut wärmeisolierenden rahmenartigenAufnahme eingesetzt sein.

Um bei Heizbetrieb eine Überhitzung der Peltier-Kaskadenanordnung, insbesondere Temperatur-Spitzen in den Randzonen der Peltier-Elemente zu vermeiden, ist erfindungsgemäß vorgesehen, daß zumindest einzelne der Peltier-Elemente höherer Leistung entweder elektrisch durch eine Bypaßdiode überbrückt sind, die so gepolt ist, daß bei Heizbetrieb das oder die betreffende(n) Peltier-Element(e) stromlos bleibt (bleiben). Um weiterhin Temperatur-Spitzen in den Randzonen abzubauen. ist als Ergänzung des Erfindungsgedankens vorgesehen, die Fläche der Zwischenplatte größer als die durch die beiden Flächenanordnungen von Peltier-Elementen eingenommene Gesamtfläche auszubilden, so daß die Zwischenplatte randseitig alle Peltier-Elemente überlappt.

Die Erfindung und vorteilhafte Einzelheiten werden nachfolgend anhand eines Ausführungsbeispiels mit Bezug auf die Zeichnung näher erläutert. Es zeigen:

**Fig. 1**    die Prinzipdarstellung einer zweilagigen Kaskaden-Anordnung aus Peltier-Elementen zur Verdeutlichung der Wärmebilanz bei Kühlbetrieb:

**Fig. 2**    eine der Fig. 1 entsprechende zweilagige Kaskaden-Anordnung zur Erläuterung der Wärmebilanz bei Heizbetrieb:

**Fig. 3**    den Prinzipaufbau einer thermoelektrischen Heiz- und Kühlkammer mit erfindungsgemäßen Merkmalen;

**Fig. 4**    eine erfindungsgemäße Schaltungsmaßnahme zur Vermeidung von Überhitzung der Peltier-Elemente kleinerer Leistung;

**Fig. 5**    die Prinzipdarstellung einer zweilagigen Kaskaden-Anordnung von Peltier-Elementen unterschiedlicher Leistung zur Erläuterung der Funktionsweise einer Bypaßdiode für einen Teil der Peltier-Elemente;

**Fig. 6 bis 8**    verschiedene Realisierungsmöglichkeiten für die Anordnung und Schaltung einer oder mehrerer Bypaßdioden für einen Teil der Peltier-Elemente;

**Fig. 9** die Prinzipdarstellung einer Ausführungsform nicht beanspruchten, bei der ein Teil der Peltier-Elemente durch einen Heißleiter überbrückt ist;

**Fig. 10** eine weitere Ausführungsform für eine Strombegrenzung in einem Teil der Peltier-Elemente bei Heizbetrieb einer mehrschichtigen Kaskaden-Anordnung;

**Fig. 11** die Schnittdarstellung einer Peltier-Heiz-/Kühlkammer gemäß einem erprobten Ausführungsbeispiel; und

**Fig. 12 und 13** die Längsschnitt- und die Querschnittdarstellung einer anderen erprobten Ausführungsform einer Peltier-Heiz-/Kühlkammer.

Bekanntermaßen läßt sich mit Hilfe von Peltier-Elementen recht einfach Wärme transportieren. Peltier-Elemente bestehen im Prinzip aus einer Aneinanderreihung von Thermoelementen. die aktiv mit einem externen Gleichstrom betrieben werden. Bei einer geschickten flächenartigen Anordnung und unter Einsatz speziell dotierter Halbleiter-Materialien lassen sich vergleichsweise gute Kühl- bzw. Heizeffekte erzielen. Bei Peltier-Elementen der hier in Rede stehenden Art ist immer eine Seite vorhanden, die Wärme aufnimmt (Kaltseite) und eine andere, die Wärme abgibt (Warmseite). Stapelt man zwei flächenartige Anordnungen übereinander, so erzielt man bei vergleichsweise kompakter Bauweise den Vorteil einer größeren Temperaturdifferenz.

Bei Kühlbetrieb muß (müssen) das (die) größere(n) Element(e) einerseits die eigentliche Nutz-Wärmeleistung durch welche die erwünschte Temperaturdifferenz erst entsteht sowie die Joulsche Wärmeleistung ($I^2$ x R) des oder der darüber liegenden Elements (Elemente) abpumpen. Aus diesem Grund werden häufig "pyramidenförmige" Anordnungen gewählt, wie sie unter anderem beispielsweise in der oben bereits erwähnten US-A-4 833 889 beschrieben sind.

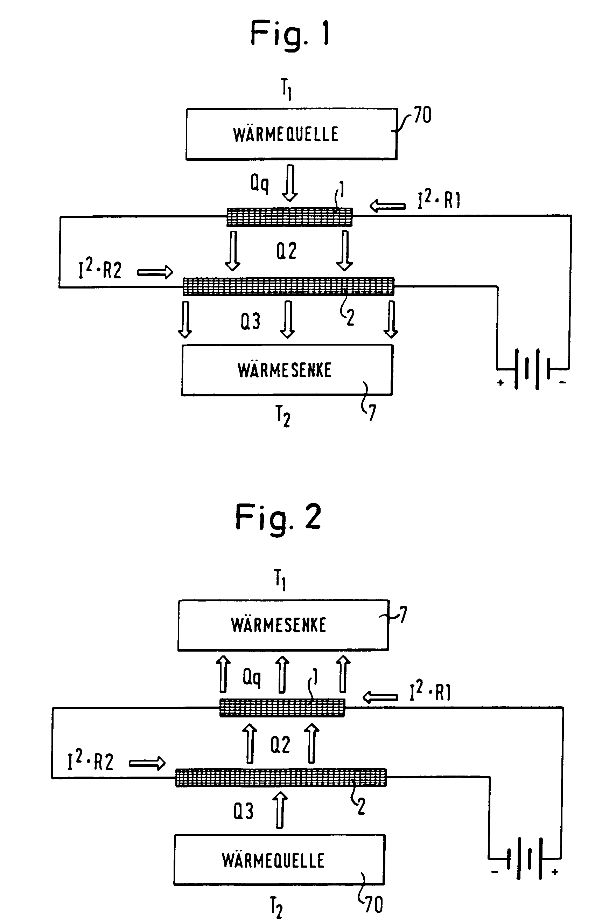

Die Wärmebilanz einer solchen pyramidenförmigen Kaskadenanordnung, d.h. die auftretenden Wärmeströme bei Heiz- bzw. Kühlbetrieb werden nachfolgend zunächst unter Bezug auf die Figuren 1 und 2 erläutert:

Den Wärmefluß bei Kühlbetrieb verdeutlicht die Fig. 1.

Es gilt:

Element 1 muß die von der Wärmequelle 70 (Temperatur $T_1$) stammende Wärmemenge wegpumpen: Q1 = Qq.

Element 2 muß außer Qq die Verlustwärme des Elements 1 wegpumpen:

$$Q2 = I^2 \cdot R1 + Qq$$

Schließlich muß die Wärmesenke 7 zusätzlich noch die Verlustwärme des Elements 2 aufnehmen. Es gilt damit:

$$Q3 = I^2 \cdot R2 + I^2 \cdot R1 + Qq$$

Die angegebenen Beziehung gelten für die Annahme:

$$Q1 << Q2 \text{ bzw. } T_1 << T_2.$$

Das System der Fig. 1 ist unter den gegebenen Annahmen und für die angegebenen auftretenden Wärmeströme richtig dimensioniert.

Den Wärmefluß bei Heizbetrieb verdeutlicht die Fig. 2.

Es gilt:

Element 1 muß wegpumpen $Q2 = I^2 \cdot R2 + Q3$.
Element 2 muß die von der Wärmequelle 70 (Temperatur $T_2$) stammende Wärmemenge wegpumpen, d.h. Q3.

Die Wärmesenke 7 muß aufnehmen: $Qq = I^2 \cdot R1 + I^2 \cdot R2 + Q3$.
Hierbei gilt wiederum die Annahme: Q2 >> Q3; $T_1$ >> $T_2$.
Es ist erkennbar. daß das kleinere Peltier-Element 1 mehr abführen muß als das größere Peltier-Element 2.

Betrachtet man nun die Wärmeströme, die die einzelnen Elemente wegzupumpen haben, so ist erkennbar, daß ein Engpaß, d.h. ein Wärmestau im Heizbetrieb bei Element 1 besteht.
Es gilt für Element 1:

Fall 1 (Fig. 1): abzuführende ("wegzupumpende") Wärme = Qq
Fall 2 (Fig. 2): abzuführende ("wegzupumpende") Wärme = $I^2$ x R2 + Q3.

Der zusätzliche Anteil der durch Element 1 bei Heizbetrieb Schwierigkeiten verursacht, ist die Joulsche Leistung ($I^2$ x R2) des größeren Peltier-Elements 2. In der Regel ist die Wärmepumpleistung des kleineren Elements 1 (der kleineren Elemente) zu klein. um diesen zusätzlichen Anteil. d.h. die Joulsche Leistung gleichzeitig abzupumpen. Daraus ergibt sich bei Heiz-betrieb ein Wärmestau. Dieser Wärmestau wird durch die Erfindung vermieden. wie nachfolgend weiter erläutert wird.

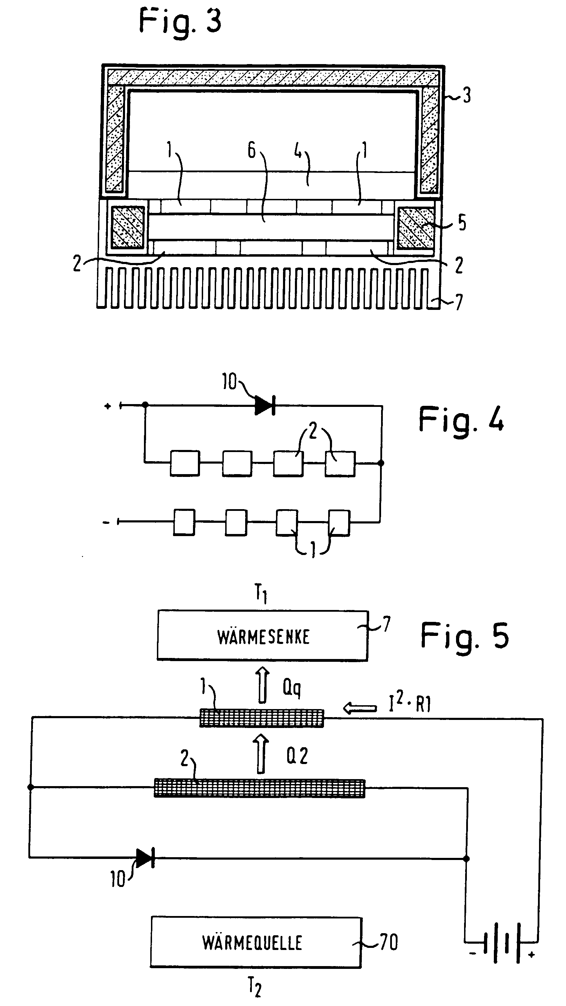

Die Prinzip-Schnittdarstellung einer thermoelektrisch betriebenen Heiz- und Kühlkammer gemäß Fig. 3 weist eine Isolierhaube 3 auf, die eine Aufnahmeplatte 4 allseitig dicht umschließt und einen auf sehr genaue Temperaturkonstanz zu kühlenden bzw. zu erwärmenden Innenraum von typischerweise 3 bis 30 1 oder auch einen noch größeren Rauminhalt gut wärmeisolierend umschließt. Unterhalb der Aufnahmeplatte 4 befindet sich eine erste innere Schichtanordnung von flächenartigen Peltier-Elementen 1 mit vergleichsweise niedrigerer Leistung, die paßgenau in vorgeformte Vertiefungen einer gut wärmeisolierenden Rahmenplatte eingesetzt sind. In bekannter Weise sind diese Peltier-Elemente in Kaskadenanordnung elektrisch verbunden. Die innere Schicht der ersten Anzahl von Peltier-Elementen 1 niedriger Leistung ist durch eine Zwischenplatte 6, die insbesondere aus spannungsfreiem Aluminiumguß hergestellt ist, von einer zweiten Anzahl von flächenartigen Peltier-Elementen 2 höherer Leistung getrennt, die ebenfalls paßgenau in entsprechende Vertiefungen einer gut wärmeisolierenden weiteren Rahmenplatte eingesetzt sind. Auch diese Peltier-Elemente 2 höherer Leistung sind elektrisch in Kaskade geschaltet und überdies in Kaskadenanordnung mit der ersten Anzahl von Peltier-Elementen 1 geringerer Leistung verbunden. Eine umlaufende, stark isolierende Abdichtung ist mit Bezugshinweis 5 angegeben. Unterhalb des Schichtaufbaus von erster Anzahl von Peltier-Elementen 1, Zwischenplatte 6 und zweiter Anzahl von Peltier-Elementen 2 ist ein Kühlkörper 7 angebracht, der für einen Abtransport der Wärmeverlustleistung sorgt.

Eine Lage der Peltier-Elemente. beispielsweise die innere Schichtanordnung von Peltier-Elementen 1. kann bis zu zehn Elemente umfassen. Um Temperatur-Spitzen. insbesondere im Bereich der Randzonen der Peltier-Elemente 1 bzw. 2 zu vermeiden. steht jede Peltier-Elementeschicht mit der gemeinsamen Zwischenplatte in eng angepaßtem Kontakt. damit der Wärmewiderstand für jedes Element etwa gleich groß ist. Die Zwischenplatte 6 überlappt sämtliche Peltier-Elemente randseitig um mindestens 1 cm. Eine Überhitzung in den Randzonen der Peltier-Elemente 1 bzw. 2 ist damit wirkungsvoll verhindert.

Das oben erläuterte Überhitzungsproblem für die Peltier-Elemente 1 geringerer Leistung insgesamt läßt sich erfindungsgemäß dadurch vermeiden. daß die Joulsche Wärme der größeren Elemente 2 im Heiz-Betrieb reduziert oder ganz ausgeschaltet wird.

Verwirklichen läßt sich diese im Heiz-Betrieb erwünschte Reduzierung der Joulschen Wärme erfindungsgemäß durch eine oder mehrere Bypaßdiode(n).

Die Fig. 4 zeigt eine spezielle Schaltungsanordnung für die Kaskadenschaltung von Peltier-Elementen 1 kleinerer und Peltier-Elementen 2 größerer Leistung. Wird die Aufnahmeplatte 4 gekühlt, so transportieren die Peltier-Elemente 1 kleinerer Leistung Wärmeenergie von der Aufnahmeplatte 4 in die Zwischenplatte 6.

Die Peltier-Elemente 2 höherer Leistung müssen einen Teil ihrer eigenen Verlustleistung **und** die Verlustleistung der Peltier-Elemente 1 kleinerer Leistung abführen, wie oben erläutert wurde. Aus diesem Grund werden die näher am Kühlkörper 7 angeordneten Peltier-Elemente 2 höherer Leistung vorteilhafterweise auch flächenmäßig größer ausgelegt.

Beim Heizen läuft der Wärmeenergiefluß, wie ebenfalls oben erläutert. entgegengesetzt. Hier besteht jetzt die Gefahr, daß auf der Zwischenplatte 6 ein unzulässiger Wärmestau dadurch entsteht, daß die Peltier-Elemente 1 kleinerer Leistung die wesentlich höhere Verlustleistung der Peltier-Elemente 2 höherer Leistung nicht wegtransportieren können. Aus diesem Grund wird gemäß einer grundsätzlichen Ausführungsform der Erfindung, wie die Fig. 4 veranschaulicht, parallel zum Stromkreis der Peltier-Elemente 2 höherer Leistung eine Leistungsdiode 10 als Bypaß geschaltet. Je nach dem gewünschten Temperaturbereich und in Abhängigkeit von anderen konstruktiven Parametern kann es auch ausreichend sein, nur einzelne der Peltier-Elemente 2 höherer Leistung mit einer parallel liegenden Bypaßdiode zu versehen. Durch diese Schaltungsmaßnahme wird erreicht, daß während der Heiz-Phase nur die Peltier-Elemente 1 kleinerer Leistung arbeiten. Daraus ergibt sich der Vorteil. daß höhere Temperaturen gefahrlos angesteuert werden können.

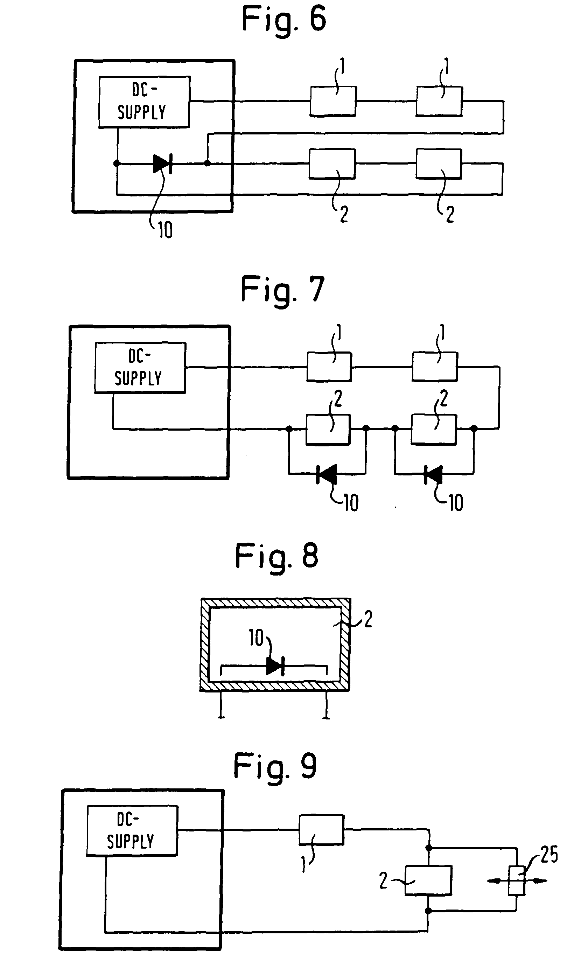

Wie die Figuren 4 und 5 veranschaulichten, ist also die einfachste Methode, die Parallelschaltung einer Leistungsdiode 10 zu den Elementen 2 derart, daß im Heizbetrieb die Diode 10 in Durchlaßrichtung arbeitet. und somit den Peltier-Strom an den Elementen 2 vorbeileitet.

Der Wärmefluß im Heizbetrieb mit Bypaßdiode läßt sich aus Fig. 5 ablesen. Es gilt wiederum unter der Annahme T1 >> T2:

Element 1 muß wegpumpen: Q2

Element 2 muß wegpumpen: 0

Die Wärmesenke 7 muß aufnehmen: $Qq = Q2 + I^2 \cdot R1$.

Zu erkennen ist, daß lediglich die Joulsche Wärme $I^2 \cdot R1$ und die Nutz-Pumpleistung Q2 von Element 1 in die Wärmesenke 7 abgeführt wird.

Das Peltier-Element 1 arbeitet jetzt im normalen zulässigen Betriebszustand.

Der Einbauort der Bypaßdiode 10 kann je nach Anwendungsfall unterschiedlich gewählt werden:

a) an der Stromquelle (vgl. Fig. 6);
b) extern an den einzelnen der Peltier-Elemente 2 (vgl. Fig. 7);
c) integriert in einzelnen oder allen der Peltier-Elemente 2 (vgl. Fig. 8).

**Zu a) (Fig. 6):**

Es wird ersichtlicherweise nur eine Bypaßdiode 10 höherer Leistung benötigt. Der Verdrahtungsaufwand ist allerdings vergleichsweise größer. Ein weiterer Vorteil besteht jedoch darin. daß man unabhängig von Temperatureinflüssen an den Peltier-Elementen 2 ist.

**Zu b) (Fig. 7):**

Ersichtlicherweise werden so viele Bypaßdioden 10 benötigt, wie Peltier-Elemente in der betreffenden Kaskade zum Einsatz kommen. Es besteht eine gewisse Abhängigkeit vom Temperatureinfluß des betreffenden Peltier-Elements. Vorteilhaft ist vor allem, daß der Verdrahtungsaufwand zwischen der Anordnung der Peltier-Elemente 2 und der Stromquelle klein ist.

**Zu c) (Fig. 8):**

Die Einbauart der integrierten Bypaßdiode 10 ist technisch und hinsichtlich des Verdrahtungsaufwands die interessanteste Lösung. Wird die Einbauart so gewählt, daß die Diode 10 auch bei höheren Temperaturen noch zuverlässig arbeitet. so sind keine Nachteile erkennbar.

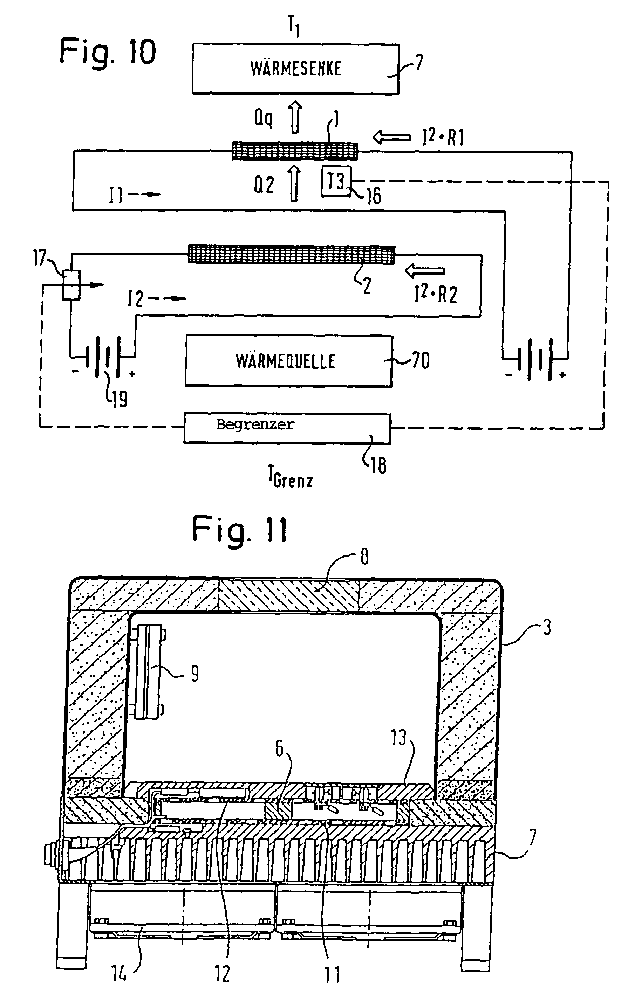

Die Integration der Bypaßdiode 10 kann bei der Herstellung des Peltier-Elements selbst erfolgen und bietet sich insbesondere dann an, wenn eine kaskadenförmige (pyramidenförmige) Anordnung von Peltier-Elementen angeboten werden soll, die auch für Heizzwecke eingesetzt werden kann. Die Figuren 9 und 10 zeigen eine nicht beanspruchte Ausführungsvariante, bei der der Strom durch die Peltier-Elemente 2 größerer Leistung in Abhängigkeit von der Warmseitentemperatur der Peltier-Elemente 1 kleinerer Leistung geregelt bzw. eingestellt wird.

Bei dieser Ausführungsvariante wird ein möglicher Nachteil der oben beschriebenen Lösung mit Bypaßdiode vermieden, der darin besteht, daß die Peltier-Elemente 2 größerer Leistung bereits dann nicht mehr mitwirken, wenn die Temperatur-Überhöhung noch zu keiner kritischen Situation für die Peltier-Elemente 1 geführt hat. Will man beispielsweise die Temperatur T1 extrem schnell ansteigen lassen, so kann es natürlich von Interesse sein, die Peltier-Elemente 2 so lange wie möglich mitzubetreiben.

Eine erste Möglichkeit, dieser Forderung zu genügen. besteht darin, die Stromquelle für die Peltier-Elemente 2 in Abhängigkeit von der Warmseitentemperatur T3 der Peltier-Elemente 1 so zu begrenzen, daß der zulässige Maximaltemperaturwert während des Heizbetriebs nicht überschritten wird. Eine prinzipielle Funktionsweise wird durch die Fig. 10 veranschaulicht.

Ein Temperaturfühler 16 mißt die Temperatur T3 auf der Warmseite der Peltier-Elemente 1 und steuert einen prinzipiell bekannten Strombegrenzer 18 mit Einstellelement 17 derart, daß der Strom 12 durch die Peltier-Elemente 2 und damit die Temperatur T3 stets kleiner bleibt als eine vorgebbare Grenztemperatur $T_{Grenz}$ ($T_3 < T_{Grenz}$).

Für den Betrieb der beiden Gruppen von Peltier-Elementen 1 bzw. 2 werden zwar zwei Stromversorgungen benötigt. Dafür lassen sich aber die beiden unterschiedlichen Typen von Peltier-Elementen in ihrem jeweils optimalen Arbeitspunkt individuell betreiben.

Eine zweite, einfacherere Möglichkeit wird durch die Prinzipdarstellung der Fig. 9 veranschaulicht, bei der lediglich eine Stromversorgung benötigt wird. Dabei wird ein Heißleiter 25 so eingebaut, daß er die Temperatur T3 der Warmseite der Peltier-Elemente 1 zuverlässig mißt. Der Arbeitspunkt des Heißleiters 25 wird so gewählt, daß bei Erreichen der Grenztemperatur sein Widerstand so klein wird, daß der Strom durch die Peltier-Elemente 2 eine Größe erreicht, die nicht mehr zu einer Überhitzung der Peltier-Elemente 1 führt.

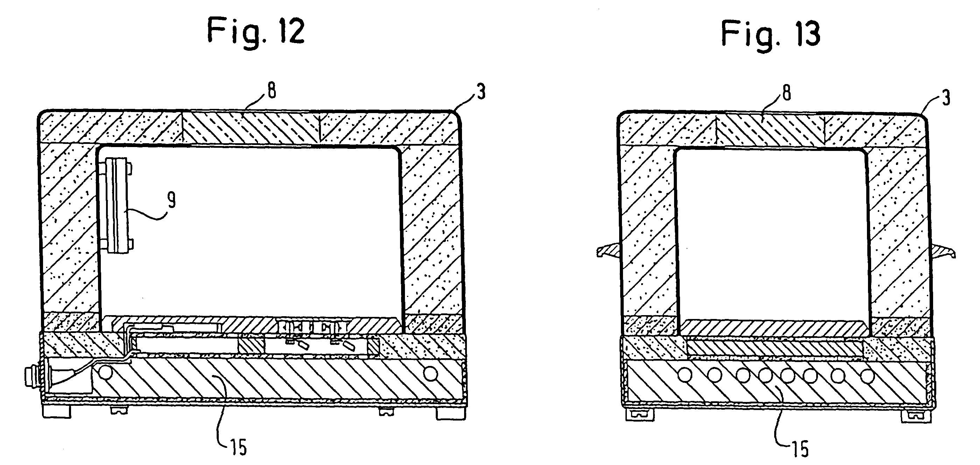

Die Fig. 11 veranschaulicht in verkleinerter Schnittdarstellung eine erprobte Ausführungsform einer thermoelektrischen Heiz- und Kühlkammer. Die bereits anhand der Fig. 3 erläuterten Teile und Baugruppen werden nicht erneut beschrieben. Auf der Oberseite der isolierenden Haube 3 ist ein Sichtfenster 8 vorgesehen. Die jeweilige Rahmenplatte für die Peltier-Elemente 1 bzw. 2 ist mit Bezugshinweis 12 bzw. 11 angegeben. Mittels eines geeichten Temperatursensors 9 läßt sich die Ist-Temperatur im Inneren der Heiz-/Kühlkammer erfassen, um den den Peltier-Elementen 1, 2 zuzuführenden Strom genau regeln zu können. Unterhalb des Kühlkörpers 7 zwischen nicht näher bezeichneten Standfüßen sind (im dargestellten Beispiel) zwei flache Axiallüfter 14 vorhanden, um im Bedarfsfall eine ausreichende Abfuhr der Verlustleistungswärme zu gewährleisten.

Bei der Ausführungsform einer Heiz- und Kühlkammer nach den Fig. 12 und 13 ist die Luftströmungskühlung durch den Kühlkörper 7, gegebenenfalls mit Unterstützung der Axiallüfter 14, durch eine Wasserkühlung 15 oder eine Kompressorkühlung kleinerer Leistung ersetzt.

Bei einer Schichtanordnung mit eng tolerierter gegenseitiger Anpassung, überlappender Fläche der Zwischenplatte 6 und eine spezielle Auswahl und Anordnung von Peltier-Elementen 1 niedrigerer Leistung einerseits und Peltier-Elementen 2 höherer Leistung andererseits wurde erreicht, daß das erfindungsgemäße Gerät über einen wesentlich größeren Temperaturbereich von beispielsweise -15 bis +95°C (luftgekühlt) bzw. -40 bis +95°C (wassergekühlt) betrieben werden kann, der für vergleichbare Kühl/Heizeinrichtungen dieser Art bisher unbekannt war.

**Patentansprüche**

1. Elektrische Heiz- oder Kühlvorrichtung, die im Bereich ihrer Grundfläche mit einer Mehrzahl von in Kaskendenanordnung hintereinandergeschalteten und in einer Heiz- bzw. Kühlfläche verteilt angeordneten Peltier-Elementen (1,2) ausgerüstet und auf einer Außenfläche mit einer wärmeabführenden Einrichtung (7) versehen ist, wobei die Peltier-Elemente (1, 2) in zwei Gruppen unterschiedlicher Leistungsstufen unterteilt und in zwei zueinander parallelen Schichten derart angeordnet sind, daß die Peltier-Elemente niedriger Leistung (1) eine erste, innere Heiz- oder Kühlfläche und die Peltier-Elemente höherer Leistung (2) eine zweite, äußere Heiz- oder Kühlfläche bilden, und wobei die Peltier-Elemente (2) höherer Leistung von der wärmeabführenden Einrichtung (7) überdeckt werden. **dadurch gekennzeichnet**, daß

- die Heiz- oder Kühlvorrichtung in eine Heiz-/Kühlkammer (3) mit Wärmeisolation eingebaut ist, und daß
- mindestens einzelne der Peltier-Elemente (2) höherer Leistung elektrisch durch eine Bypaßdiode (10) überbrückt sind. die so gepolt ist, daß bei Heizbetrieb die betreffenden Peltier-Elemente (2) stromlos bleiben.

2. Thermoelektrische Heiz- oder Kühlvorrichtung nach Anspruch 1, **dadurch gekennzeichnet**, daß die Bypaßdiode (10) alle in Kaskade geschalteten Peltier-Elemente (2) höherer Leistung elektrisch überbrückt.

3. Thermoelektrische Heiz- oder Kühlvorrichtung nach Anspruch 1, **dadurch gekennzeichnet**, daß zumindest einzelne der Peltier-Elemente (2) höherer Leistung durch jeweils eine individuell zugeordnete Bypaßdiode (10) elektrisch überbrückt sind.

4. Thermoelektrische Heiz- oder Kühlvorrichtung nach Anspruch 3, **dadurch gekennzeichnet**, daß die Bypaßdioden (10) jeweils in das zugeordnete Peltier-Element integriert sind.

## Claims

1. Electric heating or cooling device, which is equipped in the region of its base area with a plurality of Peltier elements (1, 2), connected one behind the other in cascade arrangement and arranged such that they are distributed in a heating or cooling area, and is provided on an outer surface with a heat-dissipating means (7), the Peltier elements (1, 2) being subdivided into two groups of different power stages and arranged in two mutually parallel layers in such a way that the Peltier elements of low [sic] power (1) form a first, inner heating or cooling area and the Peltier elements of higher power (2) form a second, outer heating or cooling area, and the Peltier elements (2) of higher power being covered by the heat-dissipating means (7), **characterized in that**

- the heating or cooling device is installed in a heating/cooling chamber (3) with heat insulation, and in that
- at least some of the Peltier elements (2) of higher power are electrically bypassed by a bypass diode (10) which is polarized such that during heating operation the relevant Peltier elements (2) remain currentless.

2. Thermoelectric heating or cooling device according to Claim 1, **characterized in that** the bypass diode (10) electrically bypasses all the Peltier elements (2) of higher power connected in cascade.

3. Thermoelectric heating or cooling device according to Claim 1, **characterized in that** at least some of the Peltier elements (2) of higher power are electrically bypassed by in each case an individually assigned bypass diode (10).

4. Thermoelectric heating or cooling device according to Claim 3, **characterized in that** the bypass diodes (10) are in each case integrated in the assigned Peltier element.

## Revendications

1. Dispositif électrique de chauffage ou de refroidissement équipé dans la région de sa surface de base d'une pluralité d'éléments Peltier (1, 2) montés en cascade et répartis dans une surface de chauffe ou de refroidissement, et muni sur une surface extérieure d'un dispositif de dissipation de chaleur (7), les éléments Peltier (1, 2) étant divisés en deux groupes de différents degrés de puissance et disposés en deux couches parallèles de manière que les éléments Peltier de faible puissance (1) forment une première surface de chauffe ou de refroidissement intérieure et les éléments Peltier d'une puissance plus grande (2), une seconde surface de chauffe ou de refroidissement extérieure, et les éléments Peltier (2) de puissance supérieure étant recouverts par le dispositif de dissipation de chaleur (7), **caractérisé en ce** que

- le dispositif de chauffage ou de refroidissement est intégré dans une chambre de chauffage/refroidissement (3) avec isolation thermique, et que
- au moins certains des éléments Peltier (2) de puissance supérieure sont électriquement court-circuités par une diode de dérivation (10) laquelle est polarisée de telle façon qu'en mode de chauffage, les éléments Peltier (2) ne sont pas alimentés en courant.

2. Dispositif thermoélectrique de chauffage ou de refroidissement selon la revendication 1, caractérisé en ce que la diode de dérivation (10) court-circuite tous les éléments Peltier (2) de puissance supérieure montés en cascade.

3. Dispositif thermoélectrique de chauffage ou de refroidissement selon la revendication 1, caractérisé en ce qu'au moins certains des éléments Peltier (2) de puissance supérieure sont court-circuités chacun par une diode de dérivation (10) associée individuellement.

4. Dispositif thermoélectrique de chauffage ou de refroidissement selon la revendication 3, caractérisé en ce que les diodes de dérivation (10) sont intégrées à chaque fois dans l'élément Peltier associé.

# Fig. 1

# Fig. 2

## Fig. 3

## Fig. 4

## Fig. 5

$T_1$

WÄRMESENKE — 7

$Q_q$

$I^2 \cdot R1$

$Q2$

10

WÄRMEQUELLE — 70

$T_2$

## Fig. 6

## Fig. 7

## Fig. 8

## Fig. 9

## Fig. 10

T₁

WÄRMESENKE — 7

Qq    1

I²·R1

Q2    T3 — 16

I1 →

17

I2 →

2

I²·R2

WÄRMEQUELLE — 70

19

Begrenzer — 18

T_Grenz

## Fig. 11

8

3

9

13

6

7

14    12    11

Fig. 12

Fig. 13